# EUROPEAN PATENT APPLICATION

(11) **EP 2 123 909 A2**
(43) Date of publication of application: **25.11.2009**
(21) Application number: 08736737.1
(22) Date of filing: 04.03.2008
(51) Int. Cl.: F03D 11/00, F03D 7/04, H02J 3/38

(54) **MEASURING SYSTEM INTENDED FOR GRID QUALITY AND POWER CURVE TESTING IN WIND TURBINES AND POWER SUPPLY QUALITY TESTING**

(30) Priority: 05.03.2007 ES 200700570
(71) Applicant: Fundación CIRCE - Centro de Investigación de Recursos y Consumos Energéticos, María de Luna, 3 50018 Zaragoza (ES); Instrumentación Y Componentes, S.A., Ctra. de Mardid Km. 315 8 nave 3 planta calle 50012 Zaragoza (ES)
(72) Inventor: MELERO ESTELA, Julio Javier, E-50018 Zaragoza (ES); PÉREZ ARAGÜES, Juan Jose, E-50018 Zaragoza (ES); BETRÁN OTÍN, Carlos, E-50018 Zaragoza (ES); GARCÍA GARCÍA, Miguel Angel, E-50018 Zaragoza (ES); LLOMBART ESTOPIÑÁN, Andrés, E-50018 Zaragoza (ES); ZAPATA SAN MARTÍN, Roberto, E-50018 Zaragoza (ES); MOÑUX BELLOSO, Santiago Oscar, E-50018 Zaragoza (ES)
(74) Representative: Martin Santos, Victoria Sofia
(86) International application number: PCT/ES2008/070040
(87) International publication number: WO 2008/107507

(57) **Abstract**

The object of this invention is a measurement system for the power curve test and network quality in wind turbines, as well as the quality of the electrical supply in general, which comprises measurement apparatus which carried out the power curve test and various tests to determine the quality of the electrical supply thus permitting the status of the test being carried out to be visualised at any given moment, in which one of the wind turbines is provided with measurement apparatus which enables the status of the power curve test to be determined at any moment in time and remotely, in addition to analysing the network quality in the wind turbine, which issues reports configurable by a user restricting the transit of data by means of an external communications device.

## Description

### OBJECT OF THE INVENTION

The subject of this invention is a measurement system for the power curve test and network quality in wind generators, as well as the quality of electrical supply in general, which includes measurement apparatus which carries out the power curve test and the quality tests permitting visualisation of the test status at any time while it is being carried out.

Due to its special configuration, each one of the wind generators is provided with measurement apparatus which indicates the status of the power curve test at any moment in time and in a remote manner, in addition to analysing the data obtained from the wind turbine and the meteorological data which is communicated in real time.

Similarly, the measurement system permits quality tests to be made on the electricity supply using an adjustable trigger so that information may be obtained from various points in the network in a synchronised manner, and thus it is possible to obtain an overview of network at various moments in time.

Furthermore, the report issued with the results of the data obtained may be sent instantaneously to a serial port, a GSM/GPRS modem or by Ethernet to an end user, in such a way that the transmission of data is restricted to the report with its already analysed and processed data.

In addition, the measurement system may be configured and therefore it is possible to decide and create parameters at any time for the different types of test to be carried out, the power curve test in wind turbines, the network quality test in wind turbines or quality tests on the electrical supply at a point in the network which in turn may be made in various points of the electrical network in a synchronised manner.

### BACKGROUND TO THE INVENTION

Measurement systems are known in the state of the art, for use in the various tests described in the previous section, which synchronise and process the data obtained subsequently so that there are disadvantages in not knowing the status of the test in real time.

Furthermore, this applicant is unaware of the existence of specific measurement systems which include measurement apparatus for power curve tests and measurement of network quality in wind turbines, as well as carrying out a multi-point analysis of the network quality.

Until the present, the data collected from the wind turbine and sampling on an acquisition card were sent to a central processing unit which stored and processed the data showing graphics and reports of the results however, without possessing information on the status of the different tests at any given time.

Additionally, these previous systems require voluminous data flow between the wind turbine and the central processing unit, as well as large storage capacity which is not available in current systems.

Due to the growing penetration in the sector of renewal wind energy, as well as the need for detailed study of the status of electrical supply, it is necessary to analyse the quality of the energy generated either applied to wind turbines, or in general.

The IEC (International Electrotechnical Commission) 61400-12-1:2005 specifies the methods and parameters requiring analysis in order to carry out the power curve test on ten wind turbine.

Therefore, the UNE EN 61400-21:2002 regulation specifies the methods and parameters which should be analysed and the admissible ranges of these parameters which permit the quality of the energy in a wind turbine connected to the network to be determined, the UNE EN 50160:2001 standard, together with various regulations of the IEC 61000-3 series refer to network quality measures and the maximum permissible emission limits, and the requirements of the measurement systems themselves.

Furthermore, the applicant is unaware of measurement systems which permit the test to be remotely visualised, managed and configured, as well as reconfiguring it for carrying out any of the previously mentioned tests, namely the power curve test on wind turbines, the network quality measurement test in wind turbines and the test for determining the quality of electrical supply.

The asynchronous sampling of the signal causes measurement errors in both the calculation of reactive energy and the frequency components of a signal. In current systems it is not possible to eliminate errors associated with this type of sampling.

The measurement system for the power curve test and measurement of the network quality in wind turbines as well as the network quality in general resolves all the aforementioned problems.

### DESCRIPTION OF THE INVENTION

The present invention refers to a measurement system for the power curve test and network quality test in wind turbines, as well as quality of electric supply in general, which includes measurement apparatus which carries out the power curve test and the quality tests and which permits the status of the test being carried out to be visualised at any time, issuing configurable reports by a user and thus restricting the transit of data by means of an external communications device

The measurement system is provided with measurement apparatus comprising a central processing unit which governs the complete system, a data acquisition card with various analog signal entries for the voltage and power data, as well as auxiliary analog signals which permit other wind turbine parameters to be determined, such as revolutions of the turbine axis.

It is also provided with digital signal entries which permit the status of the wind turbine to be noted, either in operation or stopped, or the status of the reactive power compensation condenser batteries, air brakes or other elements.

Similarly, sensors placed in the wind turbine enable the voltage and power to be directly determined such as the speed of the blades and the change of pitch or pitch angle and also, fitted in a meteorological tower one or various air speed indicators, one or various vanes, temperature, pressure, relative humidity sensors, and rain sensors.

The measurement equipment includes a temporary synchronisation system based on GPS (global positioning system) which permits synchronisation between the electrical data from different measurement apparatus which may be situated very far from each other.

Furthermore, it presents communication possibilities using serial ports, GSM (global system for mobile communications) Ethernet for communications between the central processing unit and external elements or via radio. In this way, the measurement system may use the TCP/IP protocol on any of the physical connections implemented and therefore, it may be accessible from any place provided that it has the corresponding physical connection, Ethernet, GSM/GPRS or serial port.

Communication of the measurement system with the meteorological tower may be made in different ways using a serial port, using a wireless system or with physical cable.

Furthermore, the measurement apparatus includes software which permits the configuration of the necessary parameters for carrying out the power curve test, network quality measurement in wind turbines, as well as the quality of electrical supply in general in relation to the IEC 61400-12-1:2005, UNE EN 61400-21:2002 y IEC 61000-3 standards respectively, in addition to the date of acquisition of that data, and the results and directories of the wind turbine data and parameters.

The monitoring reports of the tests being carried out, may be partial or total, standardised or personalised and may be generated at programmed times or at the user's request. These reports may also be transmitted by the system through any of its communication devices.

The measurement system may capture wave forms with the aid of programmable trigger functions for each of the entry channels, which may be made at a single point or at various points at the same time in a synchronised manner.

Therefore, the invention refers to a measurement system for testing the power curve and network quality in wind turbines, as well as the quality of the electrical supply in general in accordance with the IEC 61400-12-1:2005, UNE EN 61400-21:2002 and IEC 61000-3 standards respectively, or with subsequent equivalent standards and regulations, or which substitute the previous ones in that the measurement equipment is configurable so that it permits decisions to be made on the test carried out at any time, the power curve tests in wind turbines, the network quality test in wind turbines or the quality tests of the electrical supply in a specific point of the network which in turn may be made at various points of the electrical network in a synchronised manner, in addition to making the parameterisation of the test being carried out in situ or remotely, and where configurable reports are issued by a user in such a way that the transit of data is limited by means of an external communications device.

### DESCRIPTION OF THE DRAWINGS

The present descriptive report is complemented by a set of plans illustrating a preferred embodiment of the invention but which is in no way restrictive.

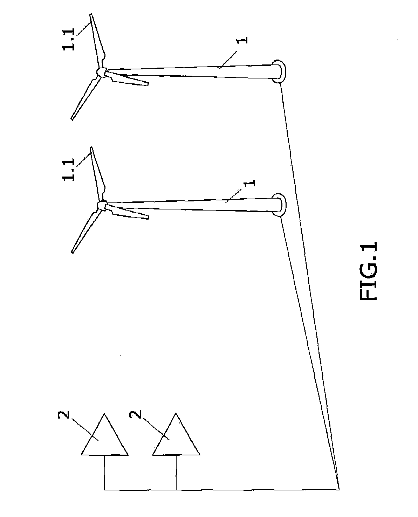

Figure 1 shows a wind turbine together with a meteorological station which forms part of the measurement system for the power curve test in wind turbines and in order to determine the network quality.

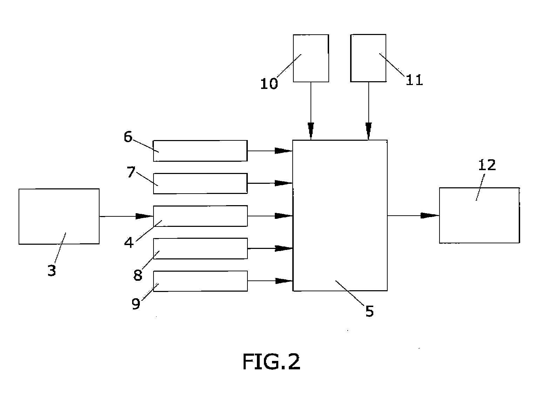

Figure 2 shows a diagram of the entries and outlets of the measurement equipment which forms part of the invention.

### PREFERRED EMBODIMENT OF THE INVENTION

In view of the foregoing, this invention refers to a measurement system for the power curve test and network quality in wind turbines, as well as quality of electrical supply in general, which includes a GPS based synchronisation system which permits the electrical data from various measurement apparatus to be synchronised, despite their being situated far apart.

The measurement system is provided with measurement apparatus (5) comprising a central processing unit, a data acquisition card with various analog signal entries (6) for voltage and power data, which in this example of a preferred embodiment are six and six respectively, as well as auxiliary analog signals (7) for determining other wind turbine (1)parameters such as the revolutions of the turbine (1) axis, which in this example of a preferred embodiment is four.

Furthermore, the measurement apparatus acquisition card (5) is also provided with on/off digital signal entries (8) which pick up the wind turbine status, either in operation or stopped, and auxiliary digital signals (9) which permit observance of the status of the reactive compensation batteries, air brakes or other elements.

The measurement system is provided with sensors placed in the wind turbines (1) which permit the voltage and the power to be directly determined along with the speed of the blades (1.1) and the change of pitch or pitch angle, and in addition, fitted in a meteorological tower, one or various air speed indicators (2) one or more vanes, as well as temperature, pressure, relative humidity sensors and rain sensors, which send meteorological signals (4) to the measurement apparatus (5) situated in the wind turbine (1) through a radio modem (3).

Additionally, the measurement apparatus (5) is provided with a hard disk for data storage, supply sources, a UPS or uninterrupted supply system to be used in the event of power cuts.

The measurement apparatus (5) also includes time and communication synchronisation elements which include a synchronisation system (10)using GPS with a precision of less than 1 µ_{S}, and devices for communication between the central processing unit and external elements, such as serial communication ports, a GSM/GPRS modem or an Ethernet network for communication between the central processing unit and external elements.

Furthermore, the measurement apparatus (5)includes software which permits the configuration of the necessary parameters for carrying out the power curve test, for measuring network quality in wind turbines, as well as the quality of electrical supply in general according to the IEC 61400-12-1:2005, UNE EN 61400-21:2002 and IEC 61000-3 standards respectively, in addition to the date of acquisition of that data, and the results and directories of the wind turbine data and parameters.

In addition, the measurement system may be configured and therefore it is possible to decide which parameters are to be created at any given time for the different types of test to be carried out, the power curve test in wind turbines, the network quality test in wind turbines or quality tests on the electrical supply at a point in the network which, in turn, may be made in various points of the electrical network in a synchronised manner, as well as permitting the parameterisation of the test which is being carried out either in situ or remotely.

In this example of a preferred embodiment regular reports are automatically sent in order to monitor the status of the test at any given moment.

The system communicates with the meteorological tower by means of a radio modem which uses the RS-232 protocol.

The basic sampling frequency is 6400 Hz per channel reaching 51200 Hz per channel when studying transients.

The essential nature of this invention is not altered by any variations in materials, form, size and arrangement of its component elements, which are described in a non-restrictive manner, with this being sufficient to proceed to its reproduction by an expert.

## Claims

1. A measurement system for testing the power curve and network quality in wind turbines, as well as the quality of the electrical supply in general according to the IEC 61400-12-1:2005, UNE EN 61400-21:2002 and IEC 61000-3 standards respectively, or to subsequent equivalent standards and regulations, or which substitute the previous ones in that it is provided with measurement apparatus (5) which is configurable so that it permits decisions to be made on the test carried out at any time, the power curve tests in wind turbines, the network quality test in wind turbines or the quality tests of the electrical supply at a point in the network which, in turn, may be made at various points of the electrical network in a synchronised manner, in addition to carrying out the parameterisation of the test being carried out in situ or remotely, and where configurable reports are issued by a user in such a way that the transit of data is limited by means of an external communications device (11).

2. Measurement system for power curve test and network quality in wind turbines, as well as the quality of the electrical supply in general, according to claim 1 **characterised in that** the measurement apparatus (5)includes a central processing unit.

3. Measurement system for power curve test and network quality in wind turbines, as well as the quality of the electrical supply in general, according to claim 1 **characterised in that** the measurement apparatus (5)is provided with a data acquisition card.

4. Measurement system for power curve test and network quality in wind turbines, as well as electrical supply in general, according to claim 3, **characterised in that** the data acquisition card is provided with various analogic signal entries (6) for the voltage and power data, as well as auxiliary analog signals (7) for determining other wind turbine parameters (1).

5. Measurement system for power curve test and network quality in wind turbines, as well as electrical supply in general according to claim 3 **characterised in that** the data acquisition card is provided with various digital signal on/off entries (8) which pick up the wind turbine status, in operation or stopped, and auxiliary digital signals (9).

6. Measurement system for the power curve test and network quality in wind turbines, as well as quality of electrical supply in general, according to claim 2 **characterised in that** the central processing unit is provided with a hard disk for data storage, supply sources and an SAI or uninterrupted supply system in the event of power cuts.

7. Measurement system for power curve test and network quality in wind turbines, as well as the quality of the electrical supply in general, according to claim 1, **characterised in that** the measurement apparatus (5)includes GPS with a precision of 1 µ_{S}.

8. Measurement system for the power curve test and network quality of wind turbines, as well as the quality of the electrical supply in general, according to claim 1, **characterised in that** it is provided with sensors fitted in the wind turbines (1) which permit the voltage and power to be determined as well as the speed of the blades (1.1) and the change of pitch or pitch angle.

9. Measurement system for the power curve test and network quality in wind turbines, as well as the supply of electrical supply in general according to claim 1, **characterised in that** it is provided, fitted in a meteorological tower, with one or various air speed indicators (2), one or various vanes, in addition to temperature, pressure, relative humidity sensors and rain sensors which send meteorological signals (4) to the measurement apparatus (5) situated in the wind turbine (1) by means of a modem radio (3).

10. Measurement system for power curve test and network quality in wind turbines, as well as electrical supply in general, according to claim 1, **characterised in that** the measurement apparatus (5) includes software which permits configuration of the necessary parameters for carrying out the power curve test, network quality measurement in wind turbines, and electrical supply quality in general in respect of the IEC 61400-12-1:2005, UNE EN 61400-21:2002 and IEC 61000-3 standards respectively, as well as the date of acquisition of that data, the results and data directories and parameters of the wind turbine.

11. Measurement system for power curve test and network quality in wind turbines, as well as electrical supply quality in general, according to claim 9, **characterised in that** the communication of the measurement system with the meteorological tower is made by means of modem radio which uses the RS-232 protocol.

12. Measurement system for power curve test and network quality in wind turbines, as well as electrical supply quality in general according to claim 1 **characterised in that** the basic sampling frequency is 6400 Hz per channel, reaching 51200 Hz per channel when studying transients.

13. Measurement system for power curve test and network quality in wind turbines, as well as the quality of the electrical supply in general, according to claim 1 **characterised in that** the communications device (11)is a serial communication port.

14. Measurement system for power curve test and network quality in wind turbines, as well as the quality of the electrical supply in general according to claim 1 **characterised in that** the communications device (11)is a GSM/GPRS modem.

15. Measurement system for power curve test and network quality in wind turbines, as well as the quality of the electrical supply in general according to claim 1 **characterised in that** the measurement apparatus (5)is an Ethernet network.

16. Measurement system for power curve test and network quality in wind turbines, as well as the quality of the electrical supply in general according to claim 1 **characterised in that** the test monitoring reports (12) being carried out may be either partial or total, and either standardised or personalised, and may be generated at programmed times or at the user's request, whereby these reports (12) may be transmitted by the system through any of its communications devices (11).
